# EUROPEAN PATENT SPECIFICATION

(11) **EP 0 453 282 B1**
(45) Date of publication and mention of the grant of the patent: **16.10.1996**
(21) Application number: 91303464.1
(22) Date of filing: 18.04.1991
(51) Int. Cl.: H04B 1/66

(54) **Digital subband encoding apparatus**
Digitale Teilbandkodierungsvorrichtung
Dispositif de codage numérique par sous-bandes

(30) Priority: 20.04.1990 JP 103045/90
(43) Date of publication of application: 23.10.1991
(73) Proprietor: SONY CORPORATION, Tokyo 141 (JP)
(72) Inventor: Akagiri, Kenzo, c/o Patents Division, Shinagawa-ku, Tokyo 141 (JP)
(74) Representative: Cotter, Ivan John

(56) References cited:
- WO-A-89/11759
- IEEE JOURNAL ON SELECTED AREAS IN COMMUNICATION. vol. 6, no. 2, February 1988, NEW YORK US,pages 314 - 323,JOHNSTON:'Transform Coding of Audio Signals Using Perceptual Noise Criteria'
- RUNDFUNKTECHNISCHE MITTEILUNGEN vol. 30, no. H3, 1986, NORDERSTEDT DE pages 117 - 123,KRAHE:'Ein Verfahren zur Datenreduktion bei digitalen Audiosignalen unter Ausnutzung Psychoakustischer Phänomene'
- BELL SYSTEM TECHNICAL JOURNAL. vol. 56, no. 5, May 1977, NEW YORK US pages 747 - 769 CROCHIERE 'On the Design of Sub-band Coders for Low-Bit-Rate Speech Communication'

## Description

This invention relates to digital signal encoding apparatus.

A previously proposed high efficiency technique for encoding voice or other audio signals employs encoding by bit allocation, according to which an input signal, such as a voice or other audio signal, is divided on the time axis or on the frequency axis into a plurality of channels and the numbers of the bits for the respective channels are adaptively allocated. Variants of the previously proposed bit allocation encoding technique for audio signals include: sub-band coding (SBC), in which an audio signal is divided on the time axis into a plurality of frequency bands for encoding; adaptive transform coding (ATC), in which a signal on the time axis is converted into a signal on the frequency axis by orthogonal conversion (transformation) and divided into a plurality of frequency bands which are then adaptively encoded: and so-called adaptive bit coding (APC-AB), in which SBC and ATC are combined so that a signal on the time axis is divided into frequency bands and the signals of the respective bands are converted into baseband signals (low-range signals) and predictively encoded by n'th order linear predictive analyses, where n is an integer equal to two or more.

With the above high efficiency techniques, adaptive encoding on a band-by-band basis is realised by calculating the energy or the inband peak value from one band to another and quantizing the signal components in each band with a number of bits allocated in accordance with the thus-calculated energy.

Recently, in the art of encoding audio signals, there has been an increasing demand for bit compression which is more satisfactory to the human auditory sense (human sense of hearing) and which is higher than that achieved with the above-mentioned previously proposed high efficiency encoding methods. For example, there is a desire to achieve encoding with higher data compression or bit compression in a manner which is rendered more acceptable to the human auditory sense by virtue of taking the characteristics of the input audio signals or the human auditory sense into account.

As regards the general characteristics of audio signals, audio signals are known to have lesser energy in their higher frequency components. For this reason, in encoding audio signals, input audio signals are subjected to preemphasis in advance of the encoding for equivalently decreasing the high range noise with respect to the signal components for improving the signal to noise (S/N) ratio. In this case, deemphasis is performed upon reproduction of the signal.

Thus, in encoding audio signals in conjunction with division into frequency bands, preemphasis and deemphasis are performed together with a quantization operation in which a number of bits is adaptively allocated to each of the frequency bands. More specifically, a digital audio signal is processed by preemphasis and subsequently divided into a plurality of frequency bands. The signal components in each band are then quantized with a number of bits allocated in conformity with the energy in each frequency band. It should be noted that, when quantization and preemphasis are performed in the same encoding operation, an arithmetical operation for finding the energy in each frequency band in the signal encoding is performed on signal components already subjected to preemphasis. Thus, it cannot be said that the numbers of quantization bits allocated on the basis of the energy of the signal components that have been subjected to preemphasis are equal to what the allocated numbers of bits should have been to conform with the properties of the actual input audio signal preceding preemphasis. Thus, there is a high chance that a voice or other audio signal decoded (after encoding) and reproduced will be perceived by the auditory sense as being different from the actually inputted voice or other audio signal.

IEEE Journal on Selected Areas in Communication, vol. 6, no. 2, February 1988, pages 314-323, Johnston, "Transform Coding of Audio Signals Using Perceptual Noise Criteria", describes a transform coder for an audio signal which uses a human auditory model to derive a short-term spectral masking curve that is used in the coder. The input signal is windowed and processed by an FFT and applied to quantisers of the coder and to an arrangement for calculating a perceptual threshold for each time segment of the input signal. The perceptual threshold is used as a noise-shaping function for the coder. Quantisation step sizes for the frequency components are determined by the bit-rate calculation process, which maintains the shape of the threshold. The quantiser step sizes are iterated to provide a fixed bit rate. The threshold calculation involves critical band analysis of the signal, applying a spreading function to the critical band spectrum, calculating a spread masking threshold, accounting for absolute thresholds, and relating the spread masking threshold to the critical band masking threshold.

According to the invention there is provided a digital signal encoding apparatus for encoding an input digital signal, the apparatus comprising:
dividing means for dividing the input digital signal into a plurality of frequency bands;
noise level setting means for setting an allowable noise level for each frequency band based on the energy in each frequency band; and
quantization means for quantizing components of the signal in each frequency band with a number of bits corresponding to a level difference between the energy in that frequency band and an output of the noise level setting means;
wherein the noise level setting means is operative to set the allowable noise level of a said frequency band on the basis of the energies of such frequency band and of another frequency band, and to provide a non-linear relationship between said energy of each frequency band and said allowable noise level, such as to conform to the characteristics of the human auditory sense.

A preferred embodiment of the invention described below provides a digital signal encoding apparatus in which higher bit compression with higher acceptability to the human auditory sense may be achieved, and in which quantization of the signal components with numbers of bits adaptively allocated in conformity with the properties of the actual input audio signal may be realized without being affected by preemphasis.

Thus, if the input digital signal has been preemphasized, the frequency divided signal supplied to the noise level setting means is corrected for the preemphasis.

According to the preferred embodiment, numbers of bits used for quantization, conforming to the characteristics of the human auditory sense, may be obtained by providing a non-linear relationship between the energy and the allowable noise level on a band-by-band basis. The allowable noise level is set on the basis of the frequency divided signal corrected for preemphasis, so that numbers of quantization bits conforming to the properties of the input digital signal, that is the properties of the input signal per se before preemphasis, may be obtained.

The invention will now be further described, by way of illustrative and non-limiting example, with reference to the accompanying drawings, in which:
Figure 1 is a schematic block circuit diagram of a digital signal encoding apparatus embodying the invention;
Figures 2 to 7 are graphs illustrating a masking effect at different levels and frequencies;
Figure 8 is a graph showing a bark spectrum;
Figure 9 is a block circuit diagram of a specific arrangement of a filter circuit of the apparatus of Figure 1;
Figure 10 is a block circuit diagram of a specific arrangement of an address control circuit of the filter circuit of Figure 9; and
Figure 11 is a graph showing a masking spectrum.

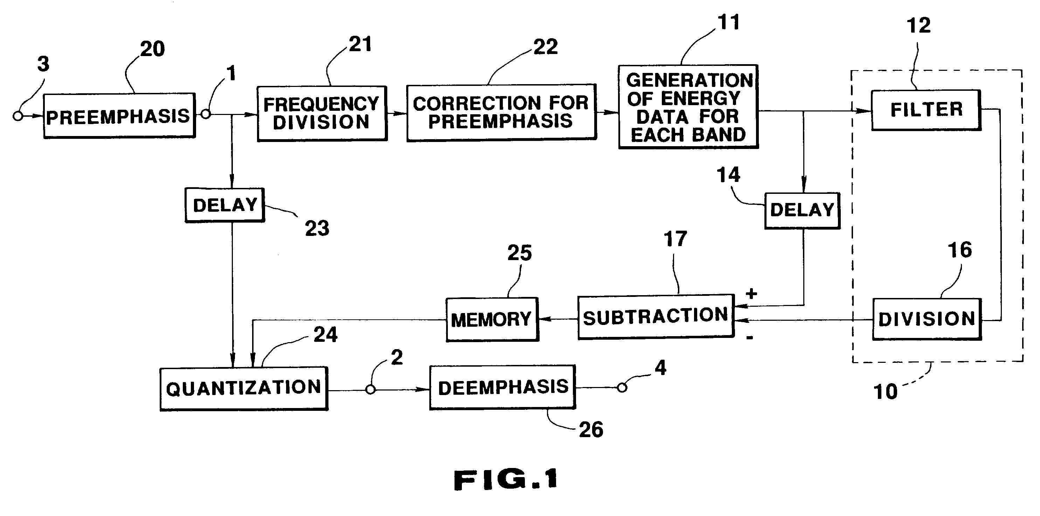

The construction of a digital signal encoding apparatus according to an illustrative embodiment of the invention is shown schematically as a block circuit diagram in Figure 1.

The apparatus shown in Figure 1 includes an allowable noise setting circuit 10 for dividing an input digital signal supplied to an input terminal 1 into a plurality of frequency bands and setting an allowable noise level based on the energy of each frequency band on a band-by-band basis, and a quantization circuit 24 for quantizing the signal components in each frequency band with a number of bits corresponding to the difference between the energy of each frequency band and the output of the allowable noise level setting circuit 10. The noise level setting circuit 10 is operative to set the allowable noise level of a frequency band under consideration on the basis of the energy of the frequency band under consideration and the energy of another frequency band, and to provide for a non-linear relationship between the allowable noise level and the energy of each frequency band. An output signal of the quantization circuit 24 is provided at an output terminal 2.

When the input digital signal supplied to the input terminal 1 of the apparatus is a preemphasized signal, that is when the signal is supplied via a preemphasis circuit 20 which emphasizes some frequency component or components of an input signal on a terminal 3 relative to others, the signal supplied to the allowable noise level setting means 10 of the present apparatus is corrected for preemphasis by a preemphasis correction circuit 22. In this case the output signal at the output terminal 2 is outputted at an output terminal 4 after deemphasis carried out by a deemphasis circuit 26.

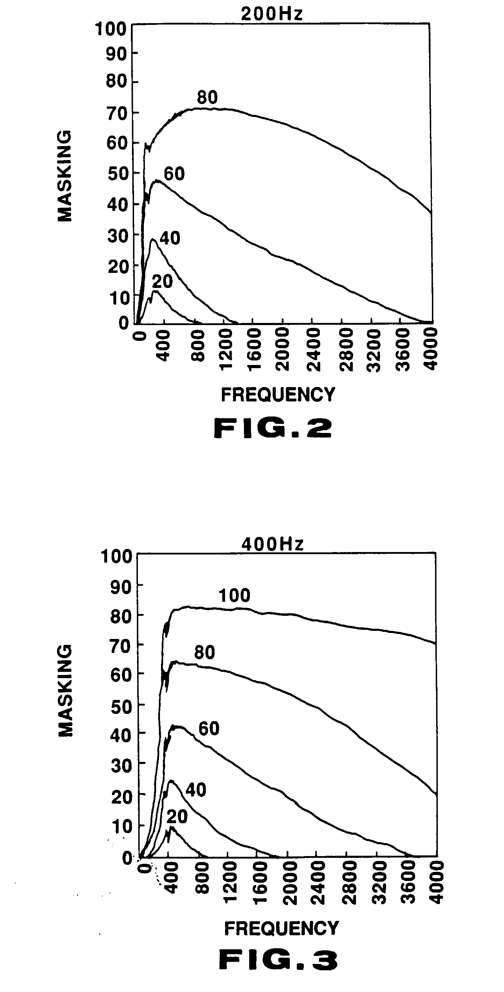

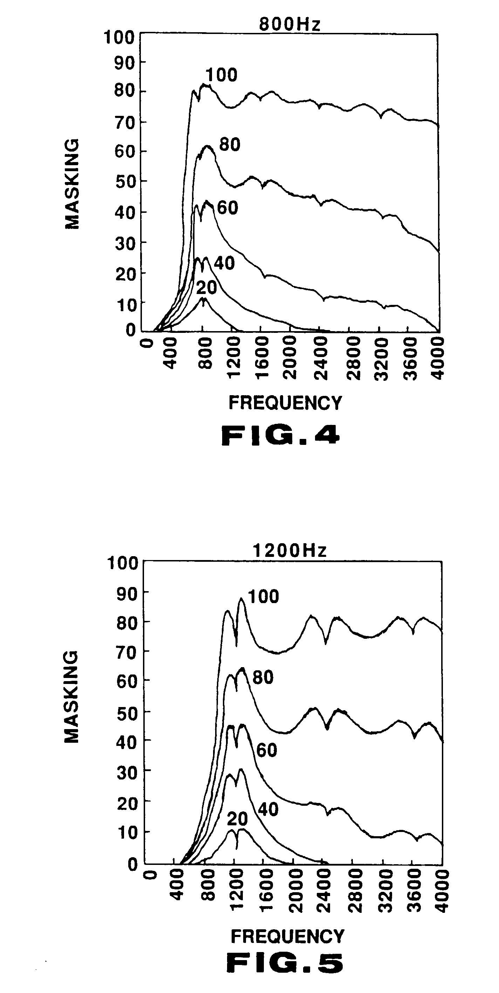

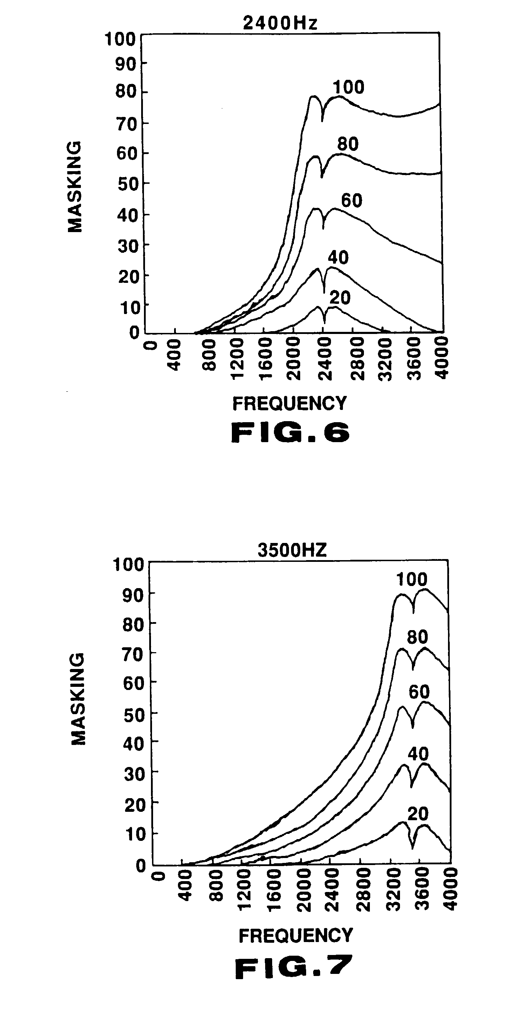

In the present allowable noise level setting circuit 10, an allowable noise level is set for each frequency band in consideration of characteristics of the human auditory sense. These characteristics include a so-called masking effect and the allowable noise level setting is carried out on the basis of this masking effect. The masking effect is a phenomenon according to which a certain sound can be masked by another sound, because of certain characteristics of the human auditory sense, and thereby becomes inaudible. In other words, the masking effect is tantamount to masking of a signal B of a certain sound or a frequency band under consideration by another signal A of another sound or another frequency band. That is, a level below a masking level of the signal B is masked by the masking effect, which may become stronger or weaken in conformity with the level of the signal A, that is the level at which the masking effect is in operation. Occasionally, the signal B may be masked in its entirety, depending on the level of the signal A. Since any noise below the masking level, if any, is masked and becomes inaudible, a level lower than this masking level may be regarded as being an allowable noise level. On the other hand, a signal level below the masking level of the signal A is also masked under its own masking effect, which becomes stronger or weaker in conformity with the prevailing level of the signal A. The signal A is also influenced by the masking effect proper to the signal B. The masking effect generally has non-linear characteristics such that, when the signal level of the signal A increases n-fold, the masking range, or the range in which the masking effect is in operation, does not increase n-fold, but only m-fold, where m is generally greater than n (m>n), so that the masking level (masking quantity or amount) is raised. The masking range and the masking level also change with the frequency of the signal A. Thus, as shown in Figures 2 to 7, the masking range and the masking level are in general changed by the signal level and frequency. In Figures 2 to 7, the masking quantity (dB) is plotted on the ordinate and the frequency (Hz) is plotted on the abscissa. Figure 2 shows an example of the masking quantity and the masking range for each of several levels of a 200 Hz signal. In similar manner, Figure 3 shows example of the masking quantity and the masking range for each of several levels of a 400 Hz signal, Figure 4 shows an example of the masking quantity and the masking range for each of several levels of an 800 Hz signal, Figure 5 shows an example of the masking quantity and the masking range for each of several levels of a 1200 Hz signal, Figure 6 shows an example of the masking quantity and the masking range for each of several levels of a 2400 Hz signal, and Figure 7 shows an example of the masking quantity and the masking range for each of several levels of a 3500 Hz signal.

The masking effect on the frequency axis means a phenomenon according to which, given an arbitrary frequency spectrum A, the spectra adjacent thereto, such as spectra B, C, D, ... on opposite sides of the spectrum A, are partially masked and become inaudible when in the form of sound. Figures 2 to 7 show the quantity of masking of the frequency spectra B, C, D, ... by the frequency spectrum A. For example, in Figure 2, the frequency spectrum to 200 Hz and the effect which a signal having a spectrum of 200 Hz has on other frequencies of 400 to 4000 Hz (masking quantity) is shown. That is, when the signal having the frequency spectrum A of 200 Hz has a level of 20 dB, for example, it can be seen from Figure 2 that the masking quantity of a signal having the frequency spectrum of 400 Hz, by the 20 dB signal of the frequency spectrum of 200 Hz, is 9 dB. It can also be seen from Figure 2 that the 20 dB signal has no (zero) masking effect on signals of 1200 to 4000 Hz.

Thus, in the present apparatus, the allowable noise level in the frequency band under consideration is set on the basis of the masking level conforming to the signal level or energy of the frequency band under consideration and the signal level or energy of another frequency band. The allowable noise level in the frequency band under consideration is set in the allowable noise level setting circuit 10. It will be noted that the above-mentioned non-linear characteristics of the masking effect are also taken into account in setting the allowable noise level in each frequency band.

In quantizing the signal components in the frequency bands, since the signal components of the signal in each frequency band which are below the allowable noise level, that is noise components, are masked, the numbers of bits allocated for quantization of the signal components below the allowable noise level may be diminished with practically no adverse effects on the sound quality due to quantization. Thus, in the present apparatus, the signal components in each frequency band are quantized in the quantization circuit 24 with a number of bits for quantization conforming to the level of the difference between the inband signal level or energy and the allowable noise level. In this manner, the allocated number of quantization bits may be reduced to provide for data compression. Also, the linear relationship between the energy and the allowable noise level is adopted in order to take the masking effect into account. For example, if the energy in the frequency band under consideration is larger, since the masking level increases non-linearly, as shown in Figures 2 to 7, the allocated number of quantization bits in the frequency band under consideration and the other band may be reduced further to provide for higher data compression. Hence, in the present embodiment, if the energy in a frequency band is high, reproduced sound which may be more agreeable to the ear may be obtained, despite the higher bit compression ratio.

To this end, the present apparatus is constructed in the following manner.

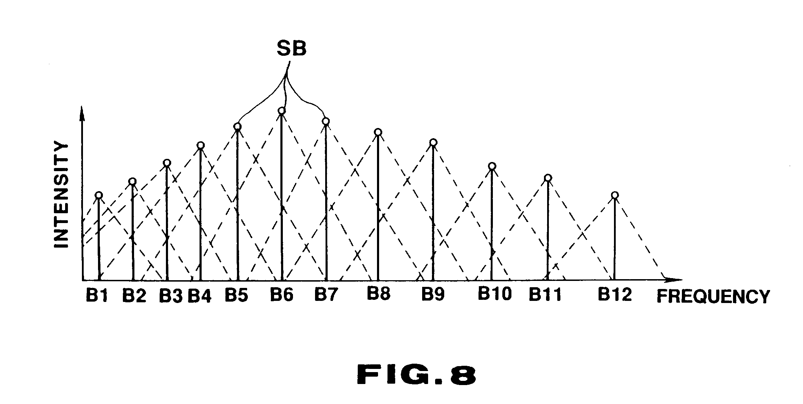

Turning again to Figure 1, a digital audio signal supplied to the input terminal 1 is supplied to a bandwidth dividing circuit 21, where the audio signal is divided into a plurality of frequency bands. An example of a technique for such frequency division comprises division into so-called critical bands which take the characteristics of the human auditory sense into account. The frequency division into critical bands is a technique of frequency division according to which the bandwidths are set so as to be wider in the direction or order of increasing frequency in order to take the characteristics of the human auditory sense into account. The frequency band signals from the bandwidth dividing circuit 21 are supplied to a sum detection circuit 11 via the above-mentioned preemphasis correction circuit 22, which is described more fully hereinbelow. In the sum detection circuit 11, the energy in each frequency band, that is the spectral intensity derived from the sum of the energies of each of the respective bands, is found. The output of the sum detection circuit 11, that is the sum spectrum of each band, is called the bark spectrum. The bark spectrum for the frequency bands is shown at SB in Figure 8, in which the number of the frequency bands (B1 to B12) is set to 12.

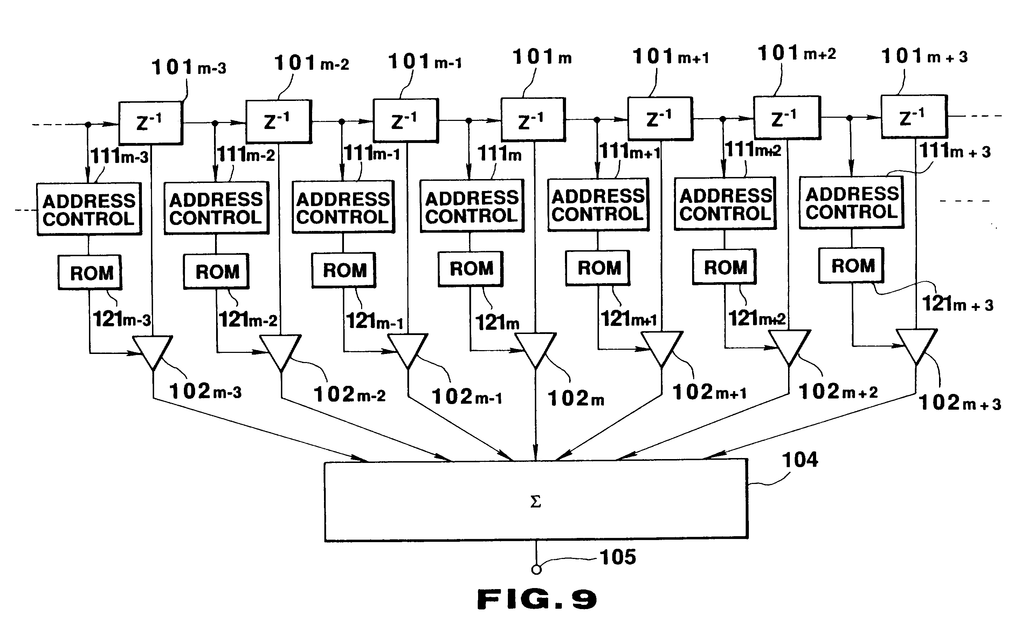

In order to take the effects on masking of the bark spectrum SB into count, a predetermined weighting function is convolved on the bark spectrum SB. To this end, the outputs of the sum detection circuit 11, that is the respective values of the bark spectrum SB, are supplied to a filter circuit 12 of the allowable noise level setting circuit 10. As shown in Figure 9, the filter circuit 12 is constituted by delay elements 101(m-3) to 101(m+3) for sequentially delaying data from the sum detection circuit 11 by Z⁻¹ (one sample), address control circuits 111(m-3) to 111(m+3) for detecting band numbers of outputs from the delay elements and the levels of the bands to generate address data on the basis of the detected results, read only memories (ROMs) 121(m-3) to 121(m+3) in which filter coefficients (that is, weighting functions) are stored and from which filter coefficients conforming to the address data from the address control circuits 111(m-3) to 111(m+3) are read out, multipliers 102(m-3) to 102(m+3) for multiplying the outputs of the delay elements 101(m-3) to 101(m+3) by the filter coefficients read out from the ROMs 121(m-3) to 121(m+3), and a summation unit or sum processor 104. That is, the outputs from the delay elements 101(m-3) to 101(m+3) are multiplied by the filter coefficients read out from the ROMs 121(m-3) to 121(m+3) by way of performing a convolution of the bark spectrum SB. By virtue of this convolution, the sum is taken of the masking effects from adjacent bark spectra, as indicated by broken lines in Figure 8. It will be noted that, given an arbitrary frequency spectrum a, the masking effect of the frequency spectrum a by other frequency spectra b, c, d, ... act on the frequency spectrum a as a sum of the spectra b, c, d ....

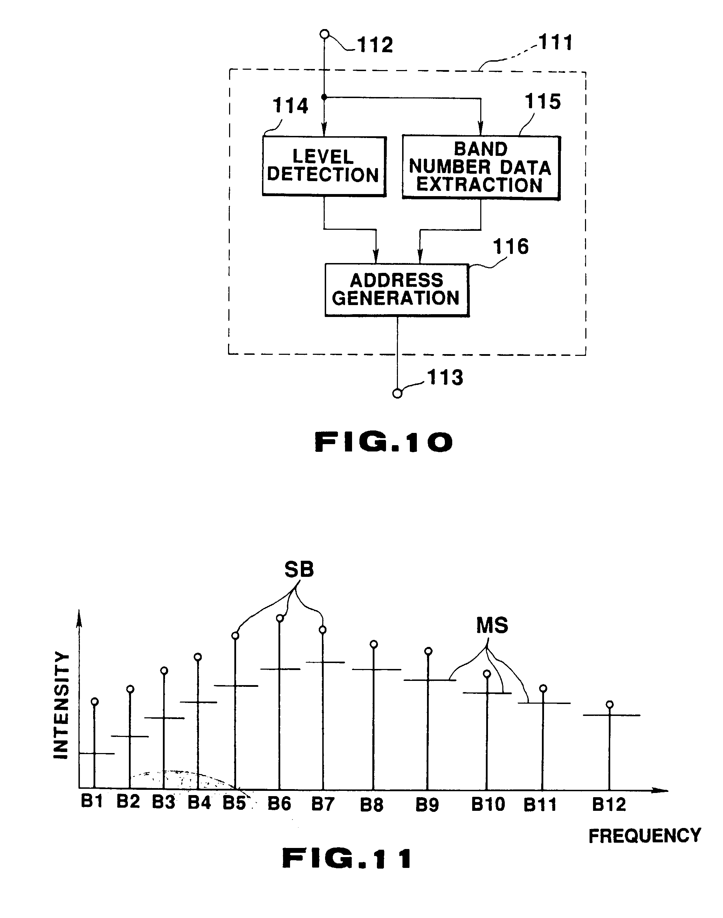

Figure 10 shows a specific arrangement that can be employed for each of the address control circuits 111(m-3) to 111(m+3) of the filter circuit 12. In Figure 10, a signal from the associated delay element is supplied to a terminal 112 of the address control circuit 111 so as to be transmitted to a level detection circuit 114 and a band number data extraction circuit 115. In the level detection circuit 14, the level (peak level or mean level) of the band is detected and, in the band number data extraction circuit 115, the band number data, that is the data indicating to which band the supplied signal belongs, is extracted. Outputs of the circuits 114 and 115 are supplied to an address generating circuit 116, where address data for the associated ROM of the filter circuit 12 conforming to these outputs are generated. The address data are transmitted to the associated ROM by means of a terminal 113. It wili be noted that extraction of the band number in the band number data extraction circuit 115 and level detection in the level detection circuit 114 are performed in order that, since the masking effect differs with the frequency and the level as shown in and described with reference to Figures 2 to 7, the filter coefficients associated with the frequency and the level may be read out from the associated ROM.

Referring back to Figure 1, an output from the filter circuit 12 is transmitted to a division circuit 16 which deconvolves the data convolved by the filter circuit 12. By virtue of this deconvolution, the masking spectrum with respect to the bark spectrum SB is obtained from the output of the filter circuit 12. That is, the masking spectrum proves to be the allowable noise spectrum. Although deconvolution generally involves a complicated processing operation, it is simplified in the present embodiment by using the division circuit 16.

The masking spectrum is transmitted to a subtractor 17, to which the output of the sum detection circuit 11, that is the bark spectrum SB, is supplied via a delay circuit 14. Thus, the masking spectrum and the bark spectrum SB are subjected in the subtractor 17 to a subtraction operation whereby, as shown in Figure 11, the bark spectrum SB is masked at lower than the level indicated by the level of the masking spectrum MS.

The output of the subtractor 17 is supplied to the quantization circuit 24 by means of a memory 25. In the quantization circuit 24, the signal supplied thereto by means of a delay circuit 23 is quantized in each frequency band on the basis of bit number data read out from the memory 25 in response to the output from the subtracter 17. In other words, the signal components in each frequency band are quantized by the quantization circuit 24 with a number of bits allocated in accordance with the masking spectrum MS (allowable noise level) obtained in the allowable noise level setting circuit 10 in consideration of the masking effect. The delay circuit 14 is provided for delaying the bark spectrum SB from the sum detection circuit 11 to 5 take account of the delay caused in the respective circuits upstream of the division circuit 16, while the delay circuit 23 is provided to take account of the delay produced in the circuits upstream of the memory 25.

It should be noted that, in consideration of the general characteristic that the energy of audio signals is low in the high frequency range, as discussed above, the input digital signal supplied to the input terminal 1 is emphasized in certain frequency components, by way of a preemphasis operation, for equivalently decreasing high frequency noise with respect to the signal components to improve the S/N ratio. That is, the signal supplied to the input terminal has been preemphasized by the preemphasis circuit 20. In such case, in order to avoid the situation that the setting of the allowable noise level by the allowable noise level setting circuit 10 is made in accordance with the preemphasized signal, the signal supplied to the allowable noise level setting circuit 10 is corrected by the preemphasis correction circuit 22. For example, if the input signal is subjected to preemphasis by the preemphasis circuit 20, the resulting signals are deemphasized by the deemphasis circuit 22 operatively associated with the emphasis circuit 20, so that signals corrected for emphasis are outputted from the circuit 22. It is possible in this manner to avoid a situation in which allowable noise levels are set on the basis of preemphasized signals, so that the signal components may be quantized with numbers of bits which are suited to the properties of the actual input audio signal. It will be noted that, if the signal supplied to the input terminal 3 is not subjected to emphasis, the correcting operation in the preemphasis correction circuit 22 is not performed.

The apparatus may be so arranged that an audio signal on the tlme axis is processed by a Fast Fourier transform (FFT) at a predetermined time interval corresponding to a frame into signals on the frequency axis, and resulting FFT coefficients composed of a real number component Re and an imaginary number component Im are further converted into data of an amplitude value Am and data of a phase value, with the data of the amplitude value Am being transmitted as the input digital data (signal) to the input terminal 1 or to the input terminal 3. Since, in general, the human auditory sense is rather insensitive to phase in the frequency range, while being relatively acutely sensitive to amplitude, digital signals subjected to such processing can meaningfully be used as input signals.

## Claims

1. A digital signal encoding apparatus for encoding an input digital signal, the apparatus comprising:
dividing means (21) for dividing the input digital signal into a plurality of frequency bands;
noise level setting means (22,11,10) for setting an allowable noise level for each frequency band based on the energy in each frequency band; and
quantization means (24,25) for quantizing components of the signal in each frequency band with a number of bits corresponding to a level difference between the energy in that frequency band and an output of the noise level setting means (10);
wherein the noise level setting means (22,11,10) is operative to set the allowable noise level of a said frequency band on the basis of the energies of such frequency band and of another frequency band, and to provide a non-linear relationship between said energy of each frequency band and said allowable noise level, such as to conform to the characteristics of the human auditory sense.

2. A digital signal encoding apparatus according to claim 1, wherein the dividing means (21) is operative to divide the input digital signal into the plurality of frequency bands such that the bandwidth of at least one frequency band of higher frequency is greater than the bandwidth of another frequency band of lower frequency.

3. A digital signal encoding apparatus according to claim 1 or claim 2, wherein the quantization means (24,25) includes memory means (25) for receiving a signal representing said level difference and for generating said number of bits.

4. A digital signal encoding apparatus according to claim 1, claim 2 or claim 3, comprising preemphasis means (20) for emphasizing a certain component or components of the input signal relative to another or others and deemphasis means (26) for deemphasizing an output of the quantization means (24,25).

5. A digital signal encoding apparatus according to claim 4, wherein the noise level setting means (22,11,10) includes correction means (22) for correcting the frequency divided signal so that the preemphasis effect caused by the premphasis means (20) is cancelled.

## Patentansprüche

1. Digitale Kodiervorrichtung zum Kodieren eines digitalen Eingangssignals
mit einer Teilereinrichtung (21) zum Aufteilen des digitalen Eingangssignals in eine Mehrzahl von Frequenzbändern,
mit einer Rausch pegeleinstelleinrichtung (22, 11, 10) zum Einstellen eines zulässigen Rausch pegels für jedes Frequenzband auf der Basis der Energie in jedem Frequenzband sowie mit einer Quantisiereinrichtung (24, 25) zum Quantisieren von Komponenten des Signals in jedem Frequenzband mit einer Bitzahl, die der Pegeldifferenz zwischen der Energie in diesem Frequenzband und dem Ausgangssignal der Rauschpegeleinstelleinrichtung (10) entspricht,
wobei die Rauschpegeleinstelleinrichtung (22, 11, 10) in der Weise wirksam ist, daß sie den zulässigen Rauschpegel eines Frequenzbands auf der Basis der Energien dieses Frequenzbands und eines weiteren Frequenzbands einstellt und eine nichtlineare Beziehung zwischen der Energie jedes Frequenzbands und dem zulässigen Rausch pegel liefert, die so beschaffen ist, daß sie mit den Eigenschaften des menschlichen Gehörsinns in Einklang steht.

2. Digitale Kodiervorrichtung nach Anspruch 1, bei der die Teilereinrichtung (21) das digitale Eingangssignal in der Weise in die Mehrzahl von Frequenzbändern aufteilt, daß die Bandbreite zumindest eines Frequenzbands höherer Frequenz größer ist als die Bandbreite eines anderen Frequenzbands niedrigerer Frequenz.

3. Digitale Kodiervorrichtung nach Anspruch 1 oder 2, bei der die Quantisiereinrichtung (24, 25) eine Speichereinrichtung (25) zur Aufnahme eines die genannte Pegeldifferenz repräsentierenden Signals und zur Erzeugung der genannten Bitzahl aufweist.

4. Digitale Kodiervorrichtung nach Anspruch 1, 2 oder 3 mit einer Preemphasiseinrichtung (20) zur Anhebung einer oder mehrerer bestimmter Komponenten des Eingangssignals relativ zu einer oder mehreren anderen Komponenten und einer Deemphasiseinrichtung (26) zur Absenkung des Ausgangssignals der Quantisiereinrichtung (24, 25).

5. Digitale Kodiervorrichtung nach Anspruch 4, bei der die Rauschpegeleinstelleinrichtung (22, 11, 10) eine Korrektureinrichtung (22) aufweist zum Korrigieren des frequenzgeteilten Signals in der Weise, daß die von der Preemphasiseinrichtung (20) verursachte Preemphasiswirkung aufgehoben wird.

## Revendications

1. Appareil de codage de signal numérique pour coder un signal numérique d'entrée, l'appareil comprenant :
un moyen de division (21) pour diviser le signal numérique d'entrée en une pluralité de bandes de fréquence ;
un moyen de réglage de niveau de bruit (22, 11, 10) pour régler un niveau de bruit admissible pour chaque bande de fréquence sur la base de l'énergie dans chaque bande de fréquence ; et
un moyen de quantification (24, 25) pour quantifier des composantes du signal dans chaque bande de fréquence avec un nombre de bits correspondant à une différence de niveau entre l'énergie dans cette bande de fréquence et une sortie du moyen de réglage de niveau de bruit (10) ;
dans lequel le moyen de réglage de niveau de bruit (22, 11, 10) est fonctionnel pour régler le niveau de bruit admissible d'une dite bande de fréquence sur la base des énergies d'une telle bande de fréquence et d'une autre bande de fréquence, et pour fournir une relation non-linéaire entre ladite énergie de chaque bande de fréquence et ledit niveau de bruit admissible, afin d'être conforme aux caractéristiques du sens auditif humain.

2. Appareil de codage de signal numérique selon la revendication 1, dans lequel le moyen de division (21) est fonctionnel pour diviser le signal numérique d'entrée en pluralité de bandes de fréquence pour que la largeur de bande d'au moins une bande de fréquence de fréquence plus élevée soit supérieure à la largeur de bande d'une autre bande de fréquence de fréquence plus basse.

3. Appareil de codage de signal numérique selon la revendication 1 ou la revendication 2, dans lequel le moyen de quantification (24, 25) comprend un moyen de mémoire (25) pour recevoir un signal représentant ladite différence de niveau et pour générer ledit nombre de bits.

4. Appareil de codage de signal numérique selon la revendication 1, la revendication 2 ou la revendication 3, comprenant un moyen de préaccentuation (20) pour préaccentuer une certaine composante ou des composantes du signal d'entrée par rapport à un autre ou des autres et un moyen de désaccentuation (26) pour désaccentuer une sortie du moyen de quantification (24, 25).

5. Appareil de codage de signal numérique selon la revendication 4, dans lequel le moyen de réglage de niveau de bruit (22, 11, 10) comprend un moyen de correction (22) pour corriger le signal divisé de fréquence pour que l'effet de préaccentuation provoqué par le moyen de préaccentuation (20) soit annulé.
